# EUROPÄISCHE PATENTSCHRIFT

(11) **EP 2 426 409 B1**
(45) Veröffentlichungstag und Bekanntmachung des Hinweises auf die Patenterteilung: **05.03.2014**
(21) Anmeldenummer: 10174853.1
(22) Anmeldetag: 01.09.2010
(51) Int. Cl.: F21V 29/02, H01L 23/433, H01L 23/467, H01L 23/473, F21V 29/00, F21Y 101/02

(54) **Vorrichtung zur Erzeugung eines Kühlluftstroms in einer Vorzugsströmungsrichtung zur Kühlung von elektrischen Bauteilen**
Device for generating a cold air flow in a preferred flow direction for cooling electrical components
Dispositif de production d'un flux d'air froid dans une direction d'écoulement préférentielle pour le refroidissement de composants électriques

(43) Veröffentlichungstag der Anmeldung: 07.03.2012
(73) Patentinhaber: Goodrich Lighting Systems GmbH, 59557 Lippstadt (DE)
(72) Erfinder: Hessling, Andre, 56179 Vallendar (DE)
(74) Vertreter: Klunker . Schmitt-Nilson . Hirsch

(56) Entgegenhaltungen:
- EP-A2- 1 020 911
- WO-A1-2010/044047
- US-A1- 2006 048 918
- US-A1- 2007 272 392

## Beschreibung

Die Erfindung betrifft eine Vorrichtung zur Erzeugung eines Kühlluftstroms in einer Vorzugsströmungsrichtung zur Kühlung von elektrischen Bauteilen, insbesondere elektrooptischen Bauteilen wie beispielsweise LEDs. Insbesondere betrifft die Erfindung die Integration einer Vorrichtung der zuvor genannten Art in einem Kühlkörper zur Kühlung von elektrischen Bauteilen, insbesondere elektrooptischen Bauteilen wie beispielsweise LEDs.

Bei Land- und Luftfahrzeugen ist man schon seit vielen Jahren bemüht, konventionelle Leuchtmittel wie beispielsweise Leuchtmittel mit Glühfäden oder Gasentladungs-Leuchtmittel durch LEDs zu ersetzen. Begünstigt wird diese Entwicklung dadurch, dass inzwischen am Markt hochleistungsfähige LEDs angeboten werden, die wegen ihrer relativ hohen Lichtintensität beispielsweise auch für Scheinwerfer an Kraftfahrzeugen und bei Flugzeugen eingesetzt werden können. Darüber hinaus existieren LED-Beleuchtungsanwendungen, bei denen die Leuchte nur kurzzeitig eingeschaltet ist, es aber auf Grund der Leistungsdichte und verfügbaren (Kühl-)Oberfläche zu einem unzulässigen Überhitzen des Leuchtmittels bzw. der Lampe innerhalb des typischen Betriebszeitraums kommen könnte. Dies ist beispielsweise der Fall bei Runway-, Turn-Off-, Taxi-, Landing- und Take-Off-Leuchten für Flugzeuge, die mit LED-Leuchtmitteln ausgestattet sind.

Zur Kühlung von LED-Leuchtmitteln werden gegenwärtig unter anderem passive Systeme, nämlich Kühlkörper eingesetzt, über die die LEDs bzw. die durch LED-Leuchtmittel erhitzten Bauteile über eine vergrößerte Oberfläche der Umgebung ausgesetzt werden. Aber auch die Kühlkörper können die Gefahr einer Überhitzung der LED-Leuchtmittel nicht verhindern, weshalb diese ab einer bestimmten Grenztemperatur gedimmt werden, damit der Leistungseintrag reduziert wird und somit dem Umstand Rechnung getragen wird, dass die Strombelastbarkeit von LEDs mit zunehmender Temperatur abnimmt.

In EP-A-1 020 911 ist eine Kühlvorrichtung für elektronische Geräte bekannt, bei der in einem Gehäuse ein Kühlluftstrom erzeugt wird, der an einer zu kühlenden Fläche entlang strömt. Quer zur Strömungsrichtung oszilliert eine Membran. An Ein- und Auslässen des Gehäuses sind gegensinnig arbeitende Rückschlagventile angeordnet. In derjenigen Phase der Bewegung der Membran, in der das Volumen zwischen dem Ein- und dem Auslass vergrößert wird, entsteht ein Unterdruck, durch den das Einlassventil geöffnet und das Auslassventil geschlossen wird. Bewegt sich die Membran in die entgegengesetzte Richtung zurück, entsteht ein Überdruck, woraufhin sich das Einlassventil schließt und das Auslassventil öffnet.

Aufgabe der Erfindung ist es, eine verbesserte Kühlung von elektrischen Bauteilen, insbesondere von elektrooptischen Bauteilen wie beispielsweise LEDs zu ermöglichen, und zwar durch eine zuverlässig arbeitende Vorrichtung zur Erzeugung eines Kühlluftstroms in einer Vorzugsströmungsrichtung zur Kühlung von elektrischen Bauteilen.

Zur Lösung dieser Aufgabe wird mit der Erfindung eine Vorrichtung zur Erzeugung eines Kühlluftstroms in einer Vorzugsströmungsrichtung zur Kühlung von elektrischen Bauteilen, insbesondere LEDs, vorgeschlagen, wobei die Vorrichtung versehen ist mit den Merkmalen des Anspruchs 1.

Nach der Erfindung wird zwischen zwei Kanalwänden ein Luftstrom erzeugt, und zwar in einer Vorzugsströmungsrichtung. Unter dem Begriff "Kanalwand" ist im Sinne der Erfindung eine Wand zu verstehen, die ein Luftvolumen bzw. allgemeiner ein Fluidum-Volumen begrenzt. Die beiden erfindungsgemäß vorgesehenen Kanalwände brauchen nicht untereinander verbunden zu sein, so dass der Bereich zwischen den Kanalwänden über zumindest einen Rand jeder Kanalwand zur Umgebung offen sein kann. Insbesondere handelt es sich bei den beiden erfindungsgemäß vorgesehenen Kanalwänden um die parallelen Kühlplattenelemente eines Kühlkörpers.

Erfindungsgemäß ist vorgesehen, dass zumindest eine der beiden Kanalwände oder aber ein zusätzliches Element zwischen den beiden Kanalwänden zumindest in Teilbereichen einer oszillierenden Bewegung aussetzbar ist. Hierzu weist die erfindungsgemäße Vorrichtung eine Oszillationsantriebseinheit auf. Der oszillierend bewegbare Teilbereich zumindest einer beiden Kanalwände (oder eines zwischen diesen angeordneten Elements) oszilliert nun in einer Richtung, die orthogonal zu der Erstreckung der Kanalwand verläuft. Von einem bestimmten Zeitpunkt und Ort der Bewegung der Luft an, wird diese in sämtliche Richtungen gleichmäßig weggedrückt, wenn sie nämlich auf diejenige Kanalwand trifft, in Richtung auf welche sich der oszillierende Teilbereich gerade bewegt. Die Innenseite mindestens einer der beiden Kanalwände (oder die Außenseite des zwischen den Kanalwänden angeordneten Elements) ist mit einer anisotropen Oberflächenstruktur versehen. Diese Oberflächenstruktur wirkt sich hinsichtlich einer an der Oberflächenstruktur entlang streichenden Luftströmung strömungstechnisch anisotrop aus. Das bedeutet, dass die Oberflächenstruktur in der Vorzugsströmungsrichtung einen geringeren Strömungswiderstand aufweist als in einer in einem Winkel zur Vorzugsströmungsrichtung und insbesondere entgegensetzt zur Vorzugsströmungsrichtung verlaufender Richtung. Durch die integrierte, anisotrope Oberflächenstruktur entsteht also ein anisotroper Luftwiderstandsbeiwert bzw. Luftströmungswiderstandsbeiwert, der die gleichschnelle Ausbreitung der "Luftwelle" behindert und die Luft in die Vorzugsströmungsrichtung lenkt. Dadurch entsteht ein Netto-Volumen- und -Massenstrom, der vorzugsweise, bezogen auf die Ausrichtung der Vorrichtung in der Einbausituation, nach oben, d.h. in Richtung des durch die natürliche Konvektion entstehenden Luftstroms gelenkt ist.

Durch die Oszillationsbewegung entsteht zunächst einmal eine Luftbewegung zwischen den Kanalwänden. Diese Luftbewegung wird im Bereich gegenüber dem oszillierenden Teilbereich umgelenkt, und zwar grundsätzlich zu allen Seiten. Durch die anisotrope Oberflächenstruktur wird nun der umgelenkte Luftstrom vorwiegend in die Vorzugsströmungsrichtung umgelenkt oder, anders ausgedrückt, fließt die Luft hauptsächlich in Vorzugsströmungsrichtung ab. Insgesamt bildet sich ein Netto-Luftstrom in Vorzugsströmungsrichtung.

Nach dem erfindungsgemäßen Vorschlag wird also die orthogonal zur Erstreckung der Kanalwände oszillierende Luftbewegung in eine Luftbewegung zwischen den beiden Kanalwänden umgelenkt, die in unterschiedlichen Raten in den verschiedensten Richtungen parallel zu den Kanalwänden und zwischen diesen strömt, wobei sich aber wegen der anisotropen Oberflächenstruktur eine Netto- bzw. Vorzugsströmungsrichtung einstellt. Bei Anwendung dieses Konzepts auf die Kühlplattenelemente eines Kühlkörpers kann die erfindungsgemäße Vorrichtung die natürliche Konvektion unterstützen, indem die Kühlplattenelemente vertikal angeordnet sind und die anisotrope Oberflächenstruktur derart ausgerichtet ist, dass die Vorzugsströmungsrichtung nach oben weist.

Ein wesentlicher Vorteil der erfindungsgemäße Vorrichtung besteht in ihrer zuverlässigen Kühlwirkung, wobei auf bewegliche Teile (mit Ausnahme des oszillierenden Teilbereichs mindestens einer der Kanalwände bzw. eines zwischen diesen angeordneten Elements) verzichtet wird. Insbesondere sind keine aktiven Kühlvorrichtungen wie beispielsweise Lüfter o.dgl. erforderlich. Derartige aktive Kühlungsmaßnahmen sind in der Flugzeugindustrie gegenwärtig nicht zulässig, da eine gravierende Beeinträchtigung der Kühlung befürchtet wird, wenn die aktiven Kühlvorrichtungen wie beispielsweise Lüfter o.dgl. ausfallen. Darüber hinaus garantiert die erfindungsgemäße Vorrichtung sowie die erfindungsgemäß Kühlmethode auch noch unter extremen Umweltbedingungen ihre Funktionalität. Derartige Umweltbedingungen bzw. extreme Umwelteinflüsse sind insbesondere an Landefahrwerken von Flugzeugen zu erwarten, wo die Vorrichtung aggressiven Medien, Schmutz, Steinschlag, Vereisungen und Vibrationen ausgesetzt wäre. Ein weiterer Vorteil der erfindungsgemäßen Vorrichtung ist darin zu sehen, dass auf eine aufwändige elektronische Ansteuerung verzichtet werden kann und die Oszillationsantriebseinheit direkt von der Fahrzeug- bzw. Flugzeugstromversorgung bei unterschiedlichen Frequenzen versorgt werden kann. Das erfindungsgemäße Kühlkonzept ist kostengünstig und konstruktiv einfach zu realisieren, wobei es extrem zuverlässig arbeitet.

Bei tieferen Temperaturen erhöht sich die Steifigkeit der Kanalwand bzw. der Kanalwände in denjenigen Regionen, in denen die oszillierenden Teilbereiche liegen. Damit ist die Effektivität der Luftbewegung bei tieferen Temperaturen eingeschränkt, was aber unkritisch ist, da bei tieferen Temperaturen weniger Kühlleistung erforderlich ist. Demgegenüber erhöht sich die Flexibilität der oszillierenden Teilbereiche der Kanalwände bzw. der Kanalwand mit höheren Temperaturen, und zwar damit genau dann, wenn maximale Kühlleistung benötigt wird.

Ein weiterer Vorteil der erfindungsgemäßen Vorrichtung ist darin zu sehen, dass durch die anisotrope Oberflächenstruktur eine Vergrößerung der Oberfläche der Kanalwand bzw. der Kanalwände erzeugt wird. Dies ist insbesondere dann von Vorteil, wenn die anisotrope Oberflächenstruktur an einem Wärme an die Umgebung abgebenden Element eines Kühlkörpers ausgebildet ist.

Darüber hinaus tritt ein weiterer wesentlicher Kühlungseffekt dadurch ein, dass durch die (rechtwinklige) Umlenkung des Luftstroms im Bereich des oszillierenden Teilbereichs mindestens einer der Kanalwände bzw. des zwischen diesen gegebenenfalls angeordneten Elements die "aerodynamische Grenzschicht" auf der Kanalwand bzw. dem oszillierenden Teilbereich wesentlich dünner wird. Unter "aerodynamischer Grenzschicht" wird dabei eine nahezu unbewegliche Luftschicht verstanden, die direkt auf der Oberfläche der Kanalwand bzw. des Teilbereichs angeordnet ist. Da die Luftbewegungen in dieser Grenzschicht normalerweise nur gering sind, kommt es demzufolge auch nur zu einem bedingten Wärmeaustausch zwischen dem betreffenden Bauteil und der Umgebung. Durch Reduktion der Dicke dieser wirksamen Grenzschicht verbessert sich demzufolge der Wärmeaustausch. Durch das aus der Funktionsweise der erfindungsgemäßen Vorrichtung resultierende "Aufbrechen" dieser Grenzschicht kann die Luft, die die Kanalwände durchströmt, wesentlich heißer werden, mithin kann sie also wesentlich mehr Energie abführen, als dies bei einer rein "parallelen" Durchströmung der Kanalwände der Fall ist.

Erfindungsgemäß ist vorgesehen, dass die anisotrope Oberflächenstruktur mehrere von der Kanalwand aufragende Erhebungen aufweist, von denen jede eine entgegengesetzt zur Vorzugsströmungsrichtung weisende Vorderseite und eine in Vorzugsströmungsrichtung weisende Rückseite aufweist, und dass die Geometrie der Vorderseite einer Erhebung zu einem größeren Strömungswiderstandskoeffizienten führt als die Geometrie der Rückseite der Erhebung.

Eine mögliche Ausgestaltung einer anisotropen Oberflächenstruktur ist darin zu sehen, dass die Vorderseiten der Erhebungen durch vordere Flanken und die Rückseiten der Erhebungen durch hintere Flanken gebildet sind und dass die hinteren Flanken steiler sind als die vorderen Flanken. Dies wird beispielsweise erreicht, wenn sich die Erhebungen im Wesentlichen quer zur Vorzugsströmungsrichtung erstrecken und ein Sägezahnprofil bilden.

Alternativ zu sich quer zur Vorzugsströmungsrichtung erstreckenden, hintereinander angeordneten "Rampen", die insgesamt ein Sägezahnprofil bilden, kann die anisotrope Oberflächenstruktur auch durch dreieckförmige oder teilzylindrische Erhebungen realisiert werden. Bei dreieckförmigen Erhebungen sind diese auf der Oberfläche derart angeordnet, dass ihre Basen entgegen der Vorzugsströmungsrichtung weisen. Im Falle von Erhebungen, die eine runde oder zylindrische Umfangsfläche in einem Teilbereich ihres Umfangs aufweisen, ansonsten aber abgeflacht sind, sind diese Erhebungen so anzuordnen, dass ihre Abflachungen in Vorzugsströmungsrichtung weisen. Insgesamt gilt für die geometrische Ausgestaltung der Erhebungen, dass sie für ein über die Oberflächenstruktur strömendes Fluid in Vorzugsströmungsrichtung einen geringeren Strömungswiderstand erzeugen als entgegengesetzt zur Vorzugsströmungsrichtung oder allgemeiner ausgedrückt als in einer in einem Winkel zur Vorzugsströmungsrichtung verlaufenden Richtung.

Bisher wurde die Erfindung für den Fall beschrieben, dass mindestens eine der beiden Kanalwände mit einem oszillierenden Teilbereich versehen ist. Zweckmäßigerweise weisen beide Kanalwände oszillierende Teilbereich auf, wobei diese oszillierenden Teilbereiche gegenläufig oszillierend bewegbar sind.

Für die Erfindung spielt es grundsätzlich keine Rolle, wo die anisotrope Oberflächenstruktur zwischen den Kanalwänden angeordnet ist. Zweckmäßig ist es aber, die oszillierende bewegbare Kanalwand auf ihrer Innenseite mit der anisotropen Oberflächenstruktur zu versehen.

Eine weitere vorteilhafte Ausgestaltung der Erfindung ist gekennzeichnet durch eine dritte Kanalwand mit einer zu den beiden anderen Kanalwänden weisenden Innenseite, wobei die zweite Kanalwand zwischen der ersten und der dritten Kanalwand angeordnet ist und zwei der dritten bzw. der ersten Kanalwand gegenüberliegende (Innen-)Seiten aufweist, die mit einer anisotropen Oberflächenstruktur versehen sind, wobei entweder (i) die zweite Kanalwand oder (ii) die erste und die dritte Kanalwand oder (iii) sämtliche drei Kanalwände oszillierend bewegbar ist/sind.

Alternativ kann eine weitere vorteilhafte Ausgestaltung der Erfindung gekennzeichnet sein durch eine dritte Kanalwand mit einer zu den beiden anderen Kanalwänden weisenden (Innen-)Seite, wobei die zweite Kanalwand zwischen der ersten und der dritten Kanalwand angeordnet ist und zwei der dritten bzw. der ersten Kanalwand gegenüberliegende Innenseiten aufweist, die mit einer anisotropen Oberflächenstruktur versehen sind, wobei die Innenflächen der ersten und der dritten Kanalwand jeweils mit einer anisotropen Oberflächenstruktur versehen sind und wobei entweder (i) die zweite Kanalwand oder (ii) die erste und die dritte Kanalwand oder (iii) sämtliche drei Kanalwände oszillierend bewegbar ist/sind.

Bei diesen beiden alternativen Ausgestaltungen der Erfindung kann zusätzlich vorgesehen sein, dass die Vorzugsströmungsrichtungen in den beiden Zwischenräumen zwischen der zweiten Kanalwand und der ersten bzw. der dritten Kanalwand gleich oder entgegengesetzt sind.

Der oszillierend bewegbare Teilbereich einer Kanalwand bzw. eines anderen zwischen zwei Kanalwänden angeordneten Elements ist zweckmäßigerweise als elastische Membran ausgebildet, die in Wirkverbindung mit der Oszillationsantriebseinheit steht. Als Wirkverbindung der Oszillationsantriebseinheit mit der Membran kommt neben einer mechanischen Verbindung insbesondere eine magnetische Kopplung in Frage, wobei die Oszillationsantriebseinheit im letztgenannten Fall ein Magnetfeld erzeugt und die Membran ein magnetisches Material aufweist, das dem Magnetfeld ausgesetzt ist, wobei die Membran infolge von Magnetismus- oder Wirbelstromeffekten oszillierend bewegbar ist.

Die oszillierend bewegbare Kanalwand weist insbesondere außerhalb der Membran zumindest auf einer ihrer Seiten, vorzugsweise auf beiden Seiten, die anisotrope Oberflächenstruktur auf.

Wie bereits oben erwähnt, lässt sich die erfindungsgemäße Vorrichtung zweckmäßigerweise in die Kühlplattenelemente eines Kühlkörpers integrieren. In diesem Fall werden also die beiden Kanalwände von zwei benachbarten Kühlplattenelementen des Kühlkörpers gebildet. Weist die erfindungsgemäße Vorrichtung gemäß einer ihrer bevorzugten Alternativen drei Kanalwände auf, so werden diese von drei benachbarten Kühlplattenelementen gebildet.

Die Erfindung wird nachfolgend anhand mehrerer Ausführungsbeispiele und unter Bezugnahme auf die Zeichnung näher erläutert. Im Einzelnen zeigen dabei:
- Fig. 1: eine Seitenansicht einer LED-Leuchte für ein Flugzeug,
- Fig. 2: eine Ansicht auf die Rückseite der LED-Leuchte, auf der ein Kühlkörper angeordnet ist,
- Fig. 3: eine perspektivische Ansicht der Leuchte von vorne,
- Fig. 4: einen Horizontalschnitt entlang der Ebene IV der Fign. 2 und 3,
- Fign. 5 und 6: die Erzeugung der Luftströmung in Vorzugsrichtung zwischen jeweils zwei Kühlplattenelementen des Kühlkörpers, wobei in diesen Figuren der Kühlkörper in Höhe der Linie V der Fig. 1 geschnitten dargestellt ist,
- Fig. 7: ein Schnitt entlang der Linie VII-VII der Fig. 1, d.h. eine Draufsicht auf die anisotrope Oberflächenstruktur mit Sägezahnprofil gemäß den Darstellungen in den Fign. 2, 5 und 6,
- Fig. 8: eine Draufsicht auf eine alternativ ausgebildete anisotrope Oberflächenstruktur und
- Fig. 9: eine Draufsicht auf eine weitere alternativ ausgebildete anisotrope Oberflächenstruktur.

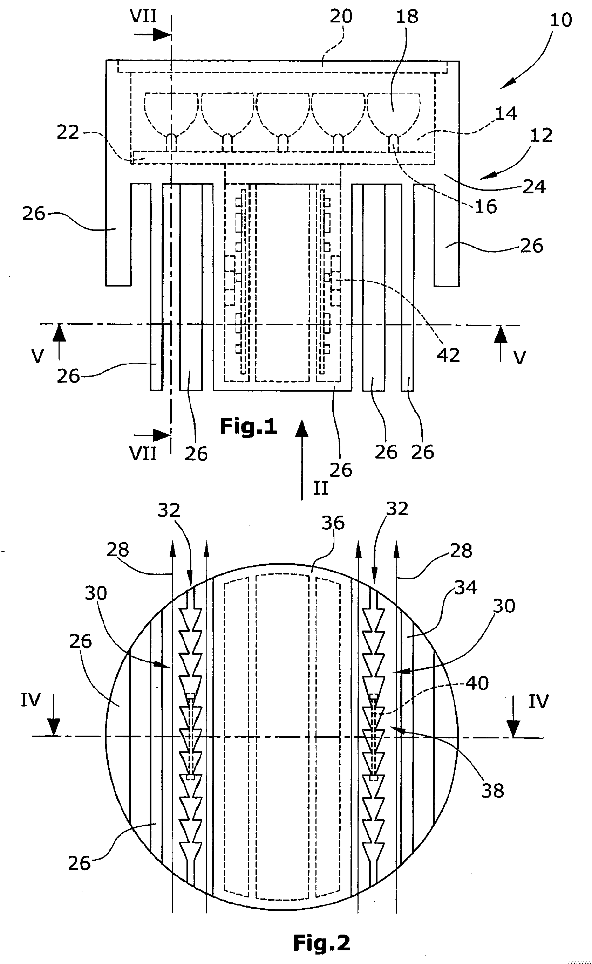

In den Fign. 1 bis 3 sind Seiten-, Unter- und perspektivische Ansichten einer LED-Flugzeugleuchte 10 gezeigt. Die Leuchte 10 weist ein Gehäuse 12 auf, das mit einem Aufnahmeraum 14 versehen ist, in dem eine Vielzahl von LEDs 16 angeordnet sind, deren Licht in (TIR-)Lichtleiter 18 eingespeist wird, die ihrerseits dieses Licht durch eine Lichtscheibe bzw. transparente Abdeckung 20 nach außen abstrahlen. Es sei angemerkt, dass die Verwendung von TIR-Lichtleitern für die Erfindung nicht zwingend erforderlich ist. Andere LED-Leuchtmittel mit oder ohne andere lichtleitende optische Elemente sind ebenfalls im Rahmen der Erfindung als LED-Leuchtmittel einsetzbar.

Die LEDs 16 sind in diesem Ausführungsbeispiel Hochleistungs-LEDs und auf einer gemeinsamen Trägerplatte 22 gehalten. Diese Trägerplatte 22 steht in thermisch leitendem Kontakt mit einem Kühlkörper 24, der das Gehäuse 12 oder ein Teil desselben der Leuchte 10 bilden kann und einzelne Kühlplattenelemente 26 aufweist. Der Kühlkörper 24 ist mit einer Vorrichtung versehen, mittels derer sich zwischen den Kühlplattenelementen 26 Luftströme in einer Vorzugsströmungsrichtung 28 (siehe die Strömungspfeile in den Fign. 2, 3, 5, 6 und 7) erzeugen lassen.

Zu diesem Zweck sind zwei der Kühlplattenelemente 26 beidseitig mit anisotropen Oberflächenstrukturen 30 versehen. Diese beiden Kühlplattenelemente 26 werden nachfolgend mit dem Begriff Kanalwand 32 bezeichnet, wobei die beiden benachbarten Kühlplattenelemente 26 mit erster und zweiter Kanalwand 34,36 bezeichnet werden. Die Kanalwand 32 ist dann die dritte Kanalwand. Die dritten Kanalwände 32 weisen zusätzlich zu den anisotropen Oberflächenstrukturen 30 oszillierend bewegbare Teilbereiche 38 in Form von Membranen 40 auf, die mit Hilfe einer Oszillationsantriebseinheit 42 in oszillierende Bewegungen versetzt werden. Bei den Oszillationsantriebseinheiten 42 handelt es sich um elektromagnetische Spulen 43, die wechselnde Magnetfelder erzeugen, denen die Membranen 40 ausgesetzt sind. Auf Grund von Magnetismus- und Wirbelstromeffekten geraten die Membranen 40 in Schwingungen quer zur Erstreckung der Kanalwände 32,34,36. Zu diesem Zweck sind die Membranen 40 mit entsprechenden magnetisch sensitiven Materialien versehen.

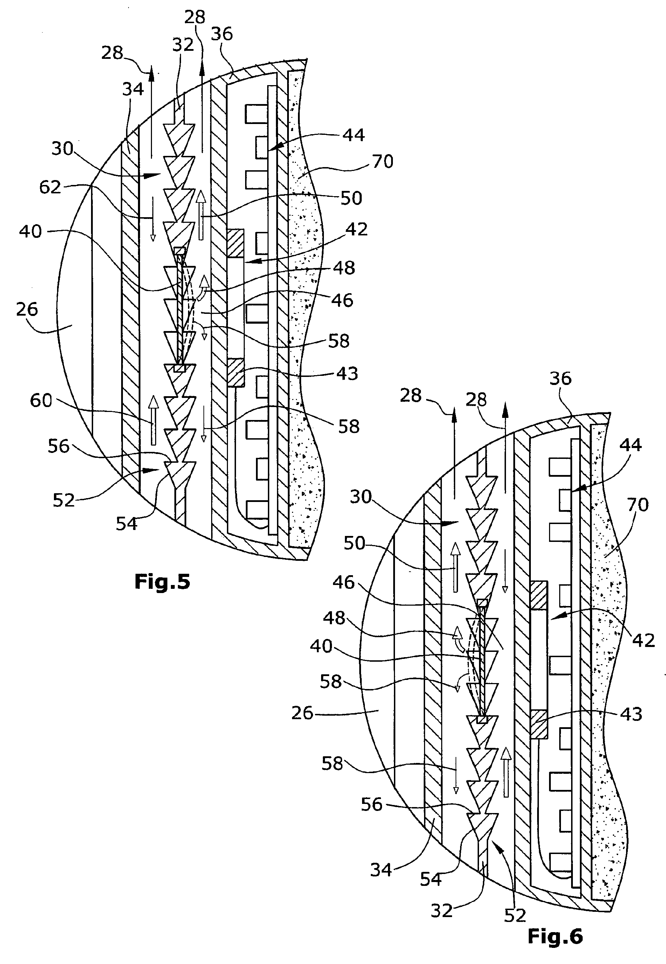

Anhand der Fign. 5 und 6 wird nachfolgend die Funktionsweise der Vorrichtung zur Erzeugung von Luftströmungen zwischen den Kanalwänden 32,34,36 erläutert. Die Spule 43 wird über eine Elektronik 44 angesteuert und ihr Magnetfeld wirkt auf die Membran 40 wechselweise anziehend und abstoßend. In Fig. 5 ist die Situation gezeigt, in der die Membran 40 angezogen wird. Das Luftvolumen bei 46 wird dann in Richtung auf die Kanalwand 36 bewegt, an der die Luft in sämtliche Richtungen umgelenkt wird. Da die Kanalwand 32 auf ihrer der Kanalwand 36 zugewandten Seite die anisotrope Oberflächenstruktur 30 aufweist, gelangt der Hauptanteil der umgelenkten Luftströmung in Richtung der Pfeile 48,50, also in Vorzugsströmungsrichtung 28. Die anisotrope Oberflächenstruktur 30 weist eine Vielzahl von Erhebungen 52 auf, die in diesem Ausführungsbeispiel jeweils keilförmig sind und insgesamt ein Sägezahnprofil erzeugen. Jede Erhebung weist eine flache Flanke 54 und eine steile Flanke 56 auf. Die flache Flanke 54 ist, bezogen auf die Vorzugsströmungsrichtung 28, stromauf der steilen Flanke 56 angeordnet. In Vorzugsströmungsrichtung 28 betrachtet, sind die Erhebungen 52 sowohl stromauf als auch stromab der vorzugsweise im Wesentlichen mittig auf der Kanalwand 32 angeordneten Membran positioniert. Damit wirken sich die stromauf der Membran 40 angeordneten Erhebungen 52 strömungstechnisch anders auf die Luftströmung aus als die Erhebungen 52, die stromab der Membran 40 angeordnet sind. Die stromauf der Membran 40 angeordneten Erhebungen 52 stellen für die an der Kanalwand 36 umgelenkte Luftströmung einen größeren Strömungswiderstand dar als die stromab der Membran 40 angeordneten Erhebungen. Mit anderen Worten strömt also der Hauptanteil der infolge der Auslenkung der Membran 40 an der Kanalwand 36 umgelenkten Luftströmung in Vorzugsströmungsrichtung 28; nur ein kleiner Teil (siehe die Pfeile 58) strömt beispielsweise entgegengesetzt zur Vorzugsströmungsrichtung.

Auf der in der Situation gemäß Fig. 5 der Oszillationsantriebseinheit 42 abgewandten Seite der Membran 40 entsteht ein Unterdruck, so dass nun von allen Seiten Luft entlang der Kanalwand 34 zu deren Mitte strömt. Diese einzelnen Luftströmungen sind wiederum der anisotropen Oberflächenstruktur 30 der Kanalwand 32 ausgesetzt, die in gleicher Weise wirkt, wie dies zuvor beschrieben wurde. Der Hauptanteil der einströmenden Luft strömt in Richtung des Pfeils 60, d.h. in Vorzugsströmungsrichtung 28, während beispielsweise nur ein geringer Teil (siehe Pfeil 62) entgegen der Vorzugsströmungsrichtung 28 strömt.

Fig. 6 zeigt die Situation, in der die Membran 40 von der Oszillationsantriebseinheit 42 abgestoßen wird. Anhand der Pfeile 48,50 und 58 ist wiederum erkennbar, dass der Hauptanteil der Luft in Vorzugsströmungsrichtung 28 strömt. Eine entsprechende Situation stellt sich auf der der Oszillationsantriebseinheit 42 zugewandten anderen Seite der Membran 40 ein.

Der zuvor beschriebene Mechanismus wirkt bei der Leuchte 10 dieses Ausführungsbeispiels zweifach, wie beispielsweise anhand der Fig. 2 klar wird. Denn der Kühlkörper 24 ist mit zwei Kühlplattenelementen 26 bzw. Kanalwänden 32 versehen, die anisotrop strukturierte Oberflächen 30 aufweisen.

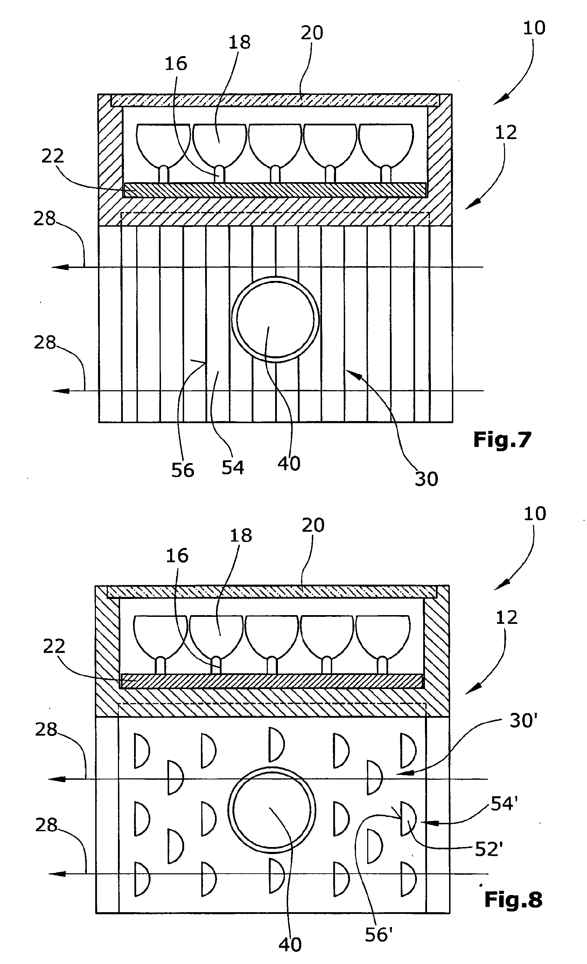

Fig. 7 zeigt eine Draufsicht auf die anisotrope Oberflächenstruktur 30.

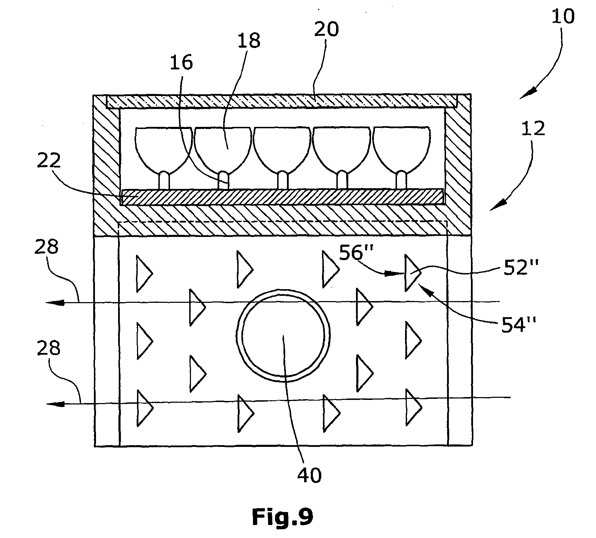

In den Fign. 8 und 9 sind zwei alternative Ausgestaltungen für anisotrope Oberflächenstrukturen 30',30" gezeigt. Sofern die übrigen Bestandteile der Leuchte, die in den Fign. 8 und 9 gezeigt sind, mit denjenigen Bestandteilen der Leuchte gemäß den Fign. 1 bis 7 identisch sind, sind sie in den Fign. 8 und 9 mit den gleichen Bezugszeichen wie in den Fign. 1 bis 7 gekennzeichnet.

In Fig. 8 weist die anisotrope Oberflächenstruktur 30' einzelne in der Draufsicht teilkreisförmige Erhebungen 52' auf. Diese Erhebungen weisen abgeflachte Seiten 56', die in Vorzugsströmungsrichtung 28 weisen, sowie konvex gewölbte Seiten 54' auf, die entgegengesetzt zur Vorzugsströmungsrichtung 28 weisen. Auch durch diese Anordnung und Ausrichtung der Erhebungen 52' ergibt sich eine Oberflächenstruktur 30', die für auf der Oberfläche entlang streichende Luft in Vorzugsströmungsrichtung einen geringeren Strömungswiderstand als entgegengesetzt zur Vorzugsströmungsrichtung bildet.

Gemäß Fig. 9 weisen die Erhebungen 52" der anisotropen Oberflächenstruktur 30" in Draufsicht eine Dreiecksform auf, wobei die Basen 56" in Vorzugsströmungsrichtung 28 weisen, während die Spitzen 54" entgegengesetzt zur Vorzugsströmungsrichtung 28 weisen. Wiederum entsteht eine strömungstechnisch anisotrop wirkende Oberflächenstruktur 30", die für auf der Oberfläche entlang streichende Luft in Vorzugsströmungsrichtung 28 einen geringeren Strömungswiderstand bildet als entgegengesetzt zur Vorzugsströmungsrichtung 28.

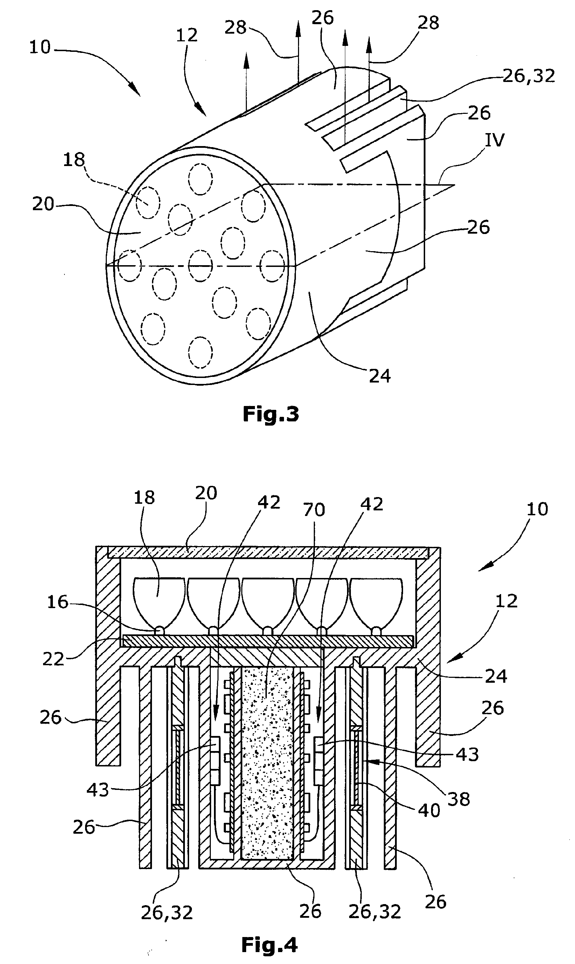

Der Mechanismus zur Erzeugung von Luftströmungen zwischen den Kühlplattenelementen des Kühlkörpers in Vorzugsströmungsrichtung kann bei der Leuchte 10 gemäß den vorstehend beschriebenen Ausführungsbeispielen einfach oder mehrfach Anwendung finden und/oder beispielsweise in Kombination mit anderen Kühlungsmechanismen und Maßnahmen zur Verhinderung einer Überhitzung der LEDs eingesetzt werden. Gemäß den Fign. 4, 5 und 6 weist der Kühlkörper eine mit einem PCM-Material 70 gefüllte Kammer auf. Das PCM-Material 70 dient, solange es in seinem festen Aggregatzustand vorliegt, in einer ersten Phase der Kühlung der LEDs. Sobald das PCM-Material 70 eine so große Wärmemenge aufgenommen hat, dass es vollständig in den flüssigen Aggregatszustand übergegangen ist, ist seine Kühlwirkung erschöpft und die weitere Kühlung kann durch den weiter oben beschriebenen Kühlmechanismus erfolgen, indem zwischen den Kühlplattenelementen eine Luftströmung in Vorzugsströmungsrichtung erzeugt wird, die die normale Luftströmung durch Konvektion von unten nach oben unterstützt. Sollte die Kühlleistung nicht ausreichend sein, kann durch Dimmung der LEDs eine Überhitzung derselben verhindert werden.

## Patentansprüche

1. Vorrichtung zur Erzeugung eines Kühlluftstroms in einer Vorzugsströmungsrichtung zur Kühlung von elektrischen Bauteilen, insbesondere LEDs, mit
- einer ersten und einer zweiten Kanalwand (34,36) mit einander zugewandten Innenseiten und
- einer Oszillationsantriebseinheit (42) zur oszillierenden Bewegung zumindest eines Teilbereichs (38) mindestens einer der beiden Kanalwände (34,36) in Richtung auf die andere Kanalwand sowie von dieser weg,
- wobei die Innenseite mindestens einer der beiden Kanalwände (34,36) eine strömungstechnisch anisotrope Oberflächenstruktur (30;30';30") aufweist, die in der Vorzugsströmungsrichtung (28) einen geringeren Strömungswiderstandskoeffizienten als in einer in einem Winkel zur Vorzugsströmungsrichtung (28) verlaufenden Richtung und insbesondere als in entgegengesetzt zur Vorzugsströmungsrichtung (28) verlaufender Richtung aufweist,
**dadurch gekennzeichnet,**
- **dass** die anisotrope Oberflächenstruktur (30;30';30") mehrere von der Kanalwand (34,36) aufragende Erhebungen (52;52';52") aufweist, von denen jede eine entgegengesetzt zur Vorzugsströmungsrichtung (28) weisende Vorderseite und eine in Vorzugsströmungsrichtung (28) weisende Rückseite aufweist, und
- **dass** die Geometrie der Vorderseite einer Erhebung (52;52';52") zu einem größeren Strömungswiderstandskoeffizienten führt als die Geometrie der Rückseite der Erhebung (52; 52'; 52").

2. Vorrichtung nach Anspruch 1, **dadurch gekennzeichnet, dass** die Vorderseiten der Erhebungen (52) durch vordere Flanken (54) und die Rückseiten der Erhebungen (52) durch hintere Flanken (56) gebildet sind und dass die hinteren Flanken (56) steiler sind als die vorderen Flanken (54).

3. Vorrichtung nach Anspruch 2, **dadurch gekennzeichnet, dass** sich die Erhebungen (52) im Wesentlichen quer zur Vorzugsströmungsrichtung (28) erstrecken und ein Sägezahnprofil bilden.

4. Vorrichtung nach einem der Ansprüche 1 bis 3, **dadurch gekennzeichnet, dass** beide Kanalwände (34,36) eine anisotrope Oberflächenstruktur (30;30';30") auf ihren einander zugewandten Innenseiten aufweisen.

5. Vorrichtung nach Anspruch 4, **dadurch gekennzeichnet, dass** beide Kanalwände (34,36) gegenläufig oszillierend bewegbar sind.

6. Vorrichtung nach einem der Ansprüche 1 bis 5, **dadurch gekennzeichnet, dass** die oszillierend bewegbare Kanalwand (34;36)auf ihrer Innenseite die anisotrope Oberflächenstruktur (30;30';30") aufweist.

7. Vorrichtung nach einem der Ansprüche 1 bis 6, **gekennzeichnet durch** eine dritte Kanalwand (32) mit einer zu den beiden anderen Kanalwänden (34,36) weisenden Innenseite, wobei die zweite Kanalwand (36) zwischen der ersten und der dritten Kanalwand (34,32) angeordnet ist und zwei der dritten bzw. der ersten Kanalwand (32,34) gegenüberliegende Innenseiten aufweist, die mit einer anisotropen Oberflächenstruktur (30;30';30") versehen sind, wobei entweder (i) die zweite Kanalwand (36) oder (ii) die erste und die dritte Kanalwand (34,32) oder (iii) sämtliche drei Kanalwände (32,34,36) oszillierend bewegbar ist/sind.

8. Vorrichtung nach einem der Ansprüche 1 bis 6, **gekennzeichnet durch** eine dritte Kanalwand (32) mit einer zu den beiden anderen Kanalwänden (34,36) weisenden Innenseite, wobei die zweite Kanalwand (36) zwischen der ersten und der dritten Kanalwand (34,32) angeordnet ist und zwei der dritten bzw. der ersten Kanalwand (32,34) gegenüberliegende Innenseiten aufweist, die mit einer anisotropen Oberflächenstruktur (30;30';30") versehen sind, wobei die Innenflächen der ersten und der dritten Kanalwand (34,32) jeweils mit einer anisotropen Oberflächenstruktur (30;30';30") versehen sind und wobei entweder (i) die zweite Kanalwand (36) oder (ii) die erste und die dritte Kanalwand (34,32) oder (iii) sämtliche drei Kanalwände (32,34,36) oszillierend bewegbar ist/sind.

9. Vorrichtung nach Anspruch 7 oder 8, **dadurch gekennzeichnet, dass** die Vorzugsströmungsrichtungen (28) in den beiden Zwischenräumen zwischen der zweiten Kanalwand (36) und der ersten bzw. der dritten Kanalwand (34,32) gleich oder entgegengesetzt sind.

10. Vorrichtung nach einem der Ansprüche 1 bis 9, **dadurch gekennzeichnet, dass** die oszillierend bewegbare Kanalwand (32;34;36) einen als oszillierend bewegbare, elastische Membran (40) ausgebildeten Teilbereich (38) aufweist, der in Wirkverbindung mit der Oszillationsantriebseinheit (42) steht.

11. Vorrichtung nach Anspruch 10, **dadurch gekennzeichnet, dass** die oszillierend bewegbare Kanalwand (32;34;36) außerhalb der Membran (40) zumindest auf einer ihrer Seiten die anisotrope Oberflächenstruktur (30;30';30") aufweist.

12. Vorrichtung nach Anspruch 10 oder 11, **dadurch gekennzeichnet, dass** die Oszillationsantriebseinheit (42) ein Magnetfeld erzeugt und dass die Membran (40) ein magnetisches Material aufweist, das dem Magnetfeld ausgesetzt ist, wobei die Membran (40) infolge von Magnetismus- oder Wirbelstromeffekten oszillierend bewegbar ist.

13. Vorrichtung nach einem der Ansprüche 1 bis 12, **gekennzeichnet durch** einen Kühlkörper (24) mit mehreren abstehenden, im Wesentlichen zueinander parallelen Kühlplattenelementen (26), von denen zwei benachbarte Kühlplattenelemente (26) die erste bzw. die zweite Kanalwand (34,36) bilden.

14. Vorrichtung nach einem der Ansprüche 1 bis 12, **gekennzeichnet durch** einen Kühlkörper (24) mit mehreren abstehenden, im Wesentlichen zueinander parallelen Kühlplattenelementen (26), von denen zwei Kühlplattenelemente (26) die erste bzw. die dritte Kanalwand (34,32) bilden, wobei die zweite Kanalwand (36) von einem zwischen den beiden Kühlplattenelementen (26) angeordneten Kühlplattenelement (26) gebildet ist.

15. Leuchte, mit
- einem LED-Leuchtmittel (16),
- einem Kühlkörper (24), der mit dem LED-Leuchtmittel (16) thermisch gekoppelt ist, und
- einer Vorrichtung zur Erzeugung eines Kühlluftstroms nach Anspruch 13 oder 14 allein oder nach Anspruch 13 oder 14 in Kombination mit mindestens einem weiteren der vorhergehenden Ansprüche.

## Claims

1. Device for generating a cooling air stream in a preferential flow direction for cooling electrical components, in particular LEDs, with
- a first and a second channel wall (34, 36) with mutually facing inner faces and
- an oscillation drive unit (42) for generating an oscillating movement of at least one partial region (38) of at least one of the two channel walls (34, 36) in the direction of the other channel wall and away therefrom,
- wherein the inner face of at least one of the two channel walls (34, 36) has a surface structure (30; 30'; 30") which is anisotropic in terms of flow technology and which has a lower flow resistance coefficient in the preferential flow direction (28) than in a direction extending at an angle relative to the preferential flow direction (28) and, in particular, in a direction extending opposite the preferential flow direction (28),
**characterized in that**
- the anisotropic surface structure (30; 30'; 30") has several protrusions (52; 52'; 52") extending from the channel wall (34, 36), each of said protrusion having a front face facing in a direction opposite the preferential flow direction (28) and a rear face facing in the preferential flow direction (28), and
- the geometry of the front face of a protrusion (52; 52';52") leads to a higher flow resistance coefficient than the geometry of the rear face of the protrusion (52; 52'; 52").

2. Device according to Claim 1, **characterized in that** the front faces of the protrusions (52) are formed by front flanks (54) and the rear faces of the protrusions (52) are formed by rear flanks (56), and **in that** the rear flanks (56) are steeper than the front flanks (54).

3. Device according to Claim 2, **characterized in that** the protrusions (52) extend substantially transversely to the preferential flow direction (28) and form a sawtooth profile.

4. Device according to one of Claims 1 to 3, **characterized in that** the two channel walls (34, 36) have an anisotropic surface structure (30; 30'; 30") on their mutually facing inner faces.

5. Device according to Claim 4, **characterized in that** the two channel walls (34, 36) are movable in an oscillating manner in opposite directions.

6. Device according to one of Claims 1 to 5, **characterized in that** the channel wall (34; 36) which is movable in an oscillating manner has the anisotropic surface structure (30; 30'; 30") on its inner face.

7. Device according to one of Claims 1 to 6, **characterized by** a third channel wall (32) with an inner face facing the two other channel walls (34, 36), wherein the second channel wall (36) is arranged between the first and the third channel wall (34, 32), and with two inner faces facing the third and respectively the first channel wall (32, 34), said two inner faces being provided with an anisotropic surface structure (30; 30'; 30"), wherein either (i) the second channel wall (36) or (ii) the first and the third channel wall (34; 32) or (iii) all three channel walls (32, 34, 36) is/are movable in an oscillating manner.

8. Device according to one of Claims 1 to 6, **characterized by** a third channel wall (32) with an inner face facing the two other channel walls (34, 36), wherein the second channel wall (36) is arranged between the first and the third channel wall (34, 32), and with two inner faces facing the third and respectively the first channel wall (32, 34), said two inner faces being provided with an anisotropic surface structure (30; 30'; 30"), wherein the inner surfaces of the first and of the third channel wall (34, 32) are provided with a respective anisotropic surface structure (30; 30'; 30") and wherein either (i) the second channel wall (36) or (ii) the first and the third channel wall (34, 32) or (iii) all three channel walls (32, 34, 36) is/are movable in an oscillating manner.

9. Device according to Claim 7 or 8, **characterized in that** the preferential flow directions (28) in the two intermediate spaces between the second channel wall (36) and the first and respectively the third channel wall (34, 32) are identical or opposite.

10. Device according to one of Claims 1 to 9, **characterized in that** the channel wall (32; 34; 36) which is movable in an oscillating manner has a partial region (38) which is formed as a resilient membrane (40) and which is movable in an oscillating manner, said partial region being operatively connected to the oscillation drive unit (42).

11. Device according to Claim 10, **characterized in that** the channel wall (32; 34; 36) which is movable in an oscillating manner has on at least one of its faces, outside the membrane (40), the anisotropic surface structure (30; 30'; 30").

12. Device according to Claim 10 or 11, **characterized in that** the oscillation drive unit (42) generates a magnetic field and **in that** the membrane (40) comprises a magnetic material which is exposed to the magnetic field, wherein the membrane (40) is movable in an oscillating manner due to magnetic or eddy-current effects.

13. Device according to one of Claims 1 to 12, **characterized by** a cooling body (24) with several projecting, substantially parallel, cooling plate elements (26), of which two adjacent cooling plate elements (26) form the first and respectively the second channel wall (34, 36).

14. Device according to one of Claims 1 to 12, **characterized by** a cooling body (24) with several projecting, substantially parallel, cooling plate elements (26) of which two cooling plate elements (26) form the first and respectively the third channel wall (34, 32), wherein the second channel wall (36) is formed by a cooling plate element (26) arranged between the two cooling plate elements (26).

15. Lamp, with
- an LED light source (16),
- a cooling body (24) which is thermally coupled to the LED light source (16), and
- a device for generating a cooling air stream according to Claim 13 or 14 alone or according to Claim 13 or 14 in combination with at least one other of the preceding claims.

## Revendications

1. Appareil de génération d'un flux d'air de refroidissement dans un sens d'écoulement préférentielle destiné à refroidir des composants électriques, en particulier des DEL, avec
- une première et une deuxième parois (34, 36) de canal possédant des faces intérieures se faisant mutuellement face et
- une unité (42) d'entraînement en oscillation permettant de générer un mouvement oscillant d'au moins une région partielle (38) d'au moins une des deux parois (34, 36) de canal dans le sens de l'autre paroi de canal et dans le sens opposé à celle-ci,
- dans lequel la face intérieure d'au moins une des deux parois (34, 36) de canal possède une structure (30 ; 30' ; 30") de surface qui est anisotrope en termes de technologie d'écoulement et qui possède un coefficient de résistance à l'écoulement plus faible dans le sens (28) d'écoulement préférentiel que dans une direction formant un angle par rapport au sens (28) d'écoulement préférentiel et, en particulier, dans un sens opposé au sens (28) d'écoulement préférentiel,
**caractérisé en ce que**
- la structure (30 ; 30' ; 30") de surface anisotrope possède plusieurs protubérances (52 ; 52' ; 52") s'étendant depuis la paroi (34, 36) de canal, chacune desdites protubérances possédant une face avant orientée dans une direction opposée au sens (28) d'écoulement préférentiel et une face arrière orientée dans le sens (28) d'écoulement préférentiel, et
- la géométrie de la face avant d'une protubérance (52 ; 52' ; 52") entraîne un coefficient de résistance à l'écoulement plus élevé que la géométrie de la face arrière de la protubérance (52 ; 52' ; 52").

2. Appareil selon la revendication 1, **caractérisé en ce que** les faces avant des protubérances (52) se composent de flancs avant (54) et les faces arrière des protubérances (52) se composent de flancs arrière (56), et **en ce que** les flancs arrière (56) sont plus inclinés que les flancs avant (54).

3. Appareil selon la revendication 2, **caractérisé en ce que** les protubérances (52) s'étendent de manière sensiblement transversal par rapport au sens (28) d'écoulement préférentiel et présentent un profil en dents de scie.

4. Appareil selon l'une des revendications 1 à 3, **caractérisé en ce que** les deux parois (34, 36) de canal possèdent une structure (30 ; 30' ; 30") de surface anisotrope sur leurs faces intérieures qui se font mutuellement face.

5. Appareil selon la revendication 4, **caractérisé en ce que** les deux parois (34, 36) de canal peuvent se déplacer de manière oscillante dans des sens opposés.

6. Appareil selon l'une des revendications 1 à 5, **caractérisé en ce que** la paroi (34 ; 36) de canal qui peut se déplacer de manière oscillante possède la structure (30 ; 30' ; 30") de surface anisotrope sur sa face intérieure.

7. Appareil selon l'une des revendications 1 à 6, **caractérisé par** une troisième paroi (32) de canal possédant une face intérieure faisant face aux deux autres parois (34, 36) de canal, dans lequel la deuxième paroi (36) de canal est disposée entre la première et la troisième parois (34, 32) de canal, et possédant deux faces intérieures faisant face respectivement à la troisième et à la première parois (32, 34) de canal, lesdites deux faces intérieures étant prévues avec une structure (30 ; 30' ; 30") de surface anisotrope, dans lequel soit i) la deuxième paroi (36) de canal soit ii) la première et la troisième parois (34 ; 32) de canal soit iii) les trois parois (32, 34, 36) de canal peu(ven)t se déplacer de manière oscillante.

8. Appareil selon l'une des revendications 1 à 6, **caracterisé par** une troisième paroi (32) de canal possédant une face intérieure faisant face aux deux autres parois (34, 36) de canal, dans lequel la deuxième paroi (36) de canal est disposée entre la première et la troisième parois (34, 32) de canal, et possédant deux faces intérieures faisant face respectivement à la troisième et à la première parois (32, 34) de canal, lesdites deux faces intérieures étant prévues avec une structure (30 ; 30' ; 30") de surface anisotrope, dans lequel les surfaces intérieures de la première et de la troisième parois (34, 32) de canal sont prévues avec une structure (30 ; 30' ; 30") de surface anisotrope correspondante, et dans lequel soit i) la deuxième paroi (36) de canal soit ii) la première et la troisième parois (34 ; 32) de canal soit iii) les trois parois (32, 34, 36) de canal peu(ven)t se déplacer de manière oscillante.

9. Appareil selon la revendication 7 ou 8, **caractérisé en ce que** les sens (28) d'écoulement préférentiels dans les deux espaces intermédiaires entre la deuxième paroi (36) de canal et respectivement la première et la troisième parois (34, 32) de canal sont identiques ou opposés.

10. Appareil selon l'une des revendications 1 à 9, **caractérisé en ce que** la paroi (32 ; 34 ; 36) de canal qui peut se déplacer de manière oscillante possède une région partielle (38) qui se présente comme une membrane élastique (40) et qui peut se déplacer de manière oscillante, ladite région partielle étant reliée de manière opérationnelle à l'unité (42) d'entraînement à oscillation.

11. Appareil selon la revendication 10, **caractérisé en ce que** la paroi (32 ; 34 ; 36) de canal qui peut se déplacer de manière oscillante possède sur au moins une de ses faces, à l'extérieur de la membrane (40), la structure (30 ; 30' ; 30") de surface anisotrope.

12. Appareil selon la revendication 10 ou 11, **caractérisé en ce que** l'unité (42) d'entraînement à oscillation génère un champ magnétique et **en ce que** la membrane (40) comprend un matériau magnétique qui est exposé au champ magnétique, dans lequel la membrane (40) peut se déplacer de manière oscillante en raison d'effets magnétiques ou d'effets des courants de Foucault.

13. Appareil selon l'une des revendications 1 à 12, **caractérisé par** un corps (24) de refroidissement possédant plusieurs éléments (26) de plaque de refroidissement, sensiblement parallèles et faisant saillie, parmi lesquels deux éléments (26) de plaque de refroidissement adjacents forment respectivement la première et la deuxième parois (34, 36) de canal.

14. Appareil selon l'une des revendications 1 à 12, **caractérisé par** un corps (24) de refroidissement possédant plusieurs éléments (26) de plaque de refroidissement, sensiblement parallèles et faisant saillie, parmi lesquels deux éléments (26) de plaque de refroidissement adjacents forment respectivement la première et la troisième parois (34, 32) de canal, dans lequel la deuxième paroi (36) de canal se compose d'un élément (26) de plaque de refroidissement disposé entre les deux éléments (26) de plaque de refroidissement.

15. Lampe, avec
- une source lumineuse (16) de type DEL,
- un corps (24) de refroidissement qui est couplé de manière thermique à la source lumineuse (16) de type DEL, et
- un appareil de génération d'un flux d'air de refroidissement selon la revendication 13 ou 14 seule ou selon la revendication 13 ou 14 en combinaison avec au moins une autre des revendications précédentes.
